# EUROPEAN PATENT APPLICATION

(11) **EP 4 803 853 A1**
(43) Date of publication of application: **09.09.2026**
(21) Application number: 25162172.8
(22) Date of filing: 06.03.2025
(51) Int. Cl.: G01B 9/02003, G01B 9/02056, G01B 9/02055, G01D 5/26, G03F 7/00

(54) **PROCESSING SYSTEM, INCREMENTAL POSITION MEASUREMENT SYSTEM, POSITIONING SYSTEM, EXPOSURE APPARATUS, PROJECTION SYSTEM FOR AN OPTICAL LITHOGRAPHY SYSTEM, METHOD TO DETERMINE A POSITION OF A MOVABLE OBJECT AND METHOD FOR CALIBRATION OF AN INCREMENTAL POSITION MEASUREMENT SYSTEM**

(71) Applicant: ASML Netherlands B.V., 5500 AH Veldhoven (NL)
(72) Inventor: JANSEN, Maarten, Jozef, 5500 AH Veldhoven (NL)
(74) Representative: ASML Netherlands B.V.

(57) **Abstract**

The invention provides a processing system for an incremental position measurement system arranged to determine a position of a movable object,
wherein the processing system comprises an input to receive, from an incremental measurement device of the incremental position measurement system, a signal representative for a position of the movable object,
wherein the processing system is arranged to determine a velocity dependent cyclic error value and/or a velocity dependent correction value of the incremental position measurement system based on the signal and a velocity of the movable object.

## Description

### FIELD

The present invention relates to a processing system for an incremental position measurement system, an incremental position measurement system and a positioning system comprising such incremental position measurement system. The invention further relates to an exposure apparatus, a projection system for an optical lithography system, a method to determine a position of a movable object and a method for calibration of an incremental position measurement system.

### BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask) onto a layer of radiation-sensitive material (resist) provided on a substrate (e.g., a wafer).

As semiconductor manufacturing processes continue to advance, the dimensions of circuit elements have continually been reduced while the amount of functional elements, such as transistors, per device has been steadily increasing over decades, following a trend commonly referred to as 'Moore's law'. To keep up with Moore's law the semiconductor industry is chasing technologies that enable to create increasingly smaller features. To project a pattern on a substrate a lithographic apparatus may use electromagnetic radiation. The wavelength of this radiation determines the minimum size of features which are patterned on the substrate. Typical wavelengths currently in use are 365 nm (i-line), 248 nm, 193 nm and 13.5 nm. A lithographic apparatus, which uses extreme ultraviolet (EUV) radiation, having a wavelength within a range of 4 nm to 20 nm, for example 6.7 nm or 13.5 nm, may be used to form smaller features on a substrate than a lithographic apparatus which uses, for example, radiation with a wavelength of 193 nm.

To accurately measure a position of a movable object in a lithographic apparatus, such as a substrate support, patterning device support or an optical element of a projection system, an incremental position measurement system, such as an interferometer system, may be applied. On the basis of a position measurement of the incremental position measurement system, a control system may be arranged to control the position of the movable object. A measurement error of the incremental position measurement system may cause the control system to move the object to a location at an offset of the desired position. Due to the offset, the pattern may not be projected properly on the substrate.

A disadvantage of known incremental position measurement systems, for example interferometer systems, is the occurrence of so-called cyclic errors. The incremental position measurement systems may provide a repetitive error signal, i.e. cyclic error, for example in dependence on the position of the movable object.

US 2019/265019 discloses a method for calibration of an incremental position measurement system to take position dependent cyclic errors into account. This method comprises the steps of:
measuring, along a measuring direction, a first position or first angular orientation of a target;
determining a first cyclic error of the incremental position measurement system for when the target is at the first position or in the first angular orientation;
measuring, along the measuring direction, a second position or second angular orientation of the target;
determining a second cyclic error of the incremental position measurement system for when the target is at the second position or in the second angular orientation, wherein the second position is at a distance from the first position in a direction other than the measuring direction;
storing a first correction value based on the first cyclic error; and
storing a second correction value based on the second cyclic error.

The first correction value and the second correction value can be used to correct a measurement value of the incremental position measurement system with the first correction value for when the target is at or near the first position, and to correct a further measurement value of the incremental position measurement system with the second correction value for when the target is at or near the second position.

Although this method of US 2019/265019 may take into account part of cyclic errors of incremental position measurement systems, measurement errors due to cyclic errors may still occur.

### SUMMARY

It is an object of the invention to provide an improved processing system for an incremental measurement device and/or an improved incremental position measurement system arranged to correct for cyclic errors. It is another object of the invention to provide an improved method to determine a position of a movable object and/or an improved method for calibration of an incremental position measurement system.

According to an aspect of the invention there is provided a processing system for an incremental position measurement system arranged to determine a position of a movable object,
wherein the processing system comprises an input to receive, from an incremental measurement device of the incremental position measurement system, a signal representative for a position of the movable object,
wherein the processing system is arranged to determine a velocity dependent cyclic error value and/or a velocity dependent correction value of the incremental position measurement system based on the signal and a velocity of the movable object.

According to an aspect of the invention, there is provided an incremental position measurement system comprising, an incremental measurement device, e.g. an interferometer or an encoder, and the processing system of any of the claims 1-5.

According to an aspect of the invention, there is provided a positioning system to position a movable object, the positioning system comprising the incremental position measurement system of claim 6.

According to an aspect of the invention, there is provided an exposure apparatus comprising such positioning system.

According to an aspect of the invention, there is provided a projection system for an optical lithography system comprising such a position system.

According to an aspect of the invention, there is provided a method to determine a position of a movable object using an incremental position measurement system comprising an incremental measurement device and a processing system, comprising the steps of:
measuring, using the incremental measurement device, a signal representative for a position of the movable object, and
determining, using the processing system, a cyclic error value and/or a cyclic error correction value of the incremental position measurement system based on the signal and a velocity of the movable object.

According to an aspect of the invention, there is provided a method for calibration of an incremental position measurement system arranged to determine a position of a movable object, comprising the steps of:
measuring multiple positions of the movable object;
determining, for each of the multiple positions, a cyclic error of the incremental position measurement system; and
determining a velocity dependent cyclic error value and/or a velocity dependent correction value of the incremental position measurement system based on the determined cyclic errors and the velocity of the movable object associated with the determined cyclic errors.

### BRIEF DESCRIPTION OF THE DRAWINGS

Embodiments of the invention will now be described, by way of example only, with reference to the accompanying schematic drawings, in which:
- Figure 1 depicts a schematic overview of a lithographic apparatus;
- Figure 2 depicts a detailed view of a part of the lithographic apparatus of Figure 1;
- Figure 3 schematically depicts a position control system;
- Figure 4 depicts an embodiment of an incremental position measurement system according to an embodiment of the invention;
- Figure 5 depicts in more detail the processing system of the incremental position measurement system of Figure 4;
- Figure 6 shows schematically a relationship between a cyclic error value and a measurement value; and
- Figures 7 and 8 show schematically relationships between cyclic error values and velocity of a movable object; and
- Figure 9 show schematically relationships between a cyclic error transfer value and velocity of a movable object.

### DETAILED DESCRIPTION

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range of about 5-100 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

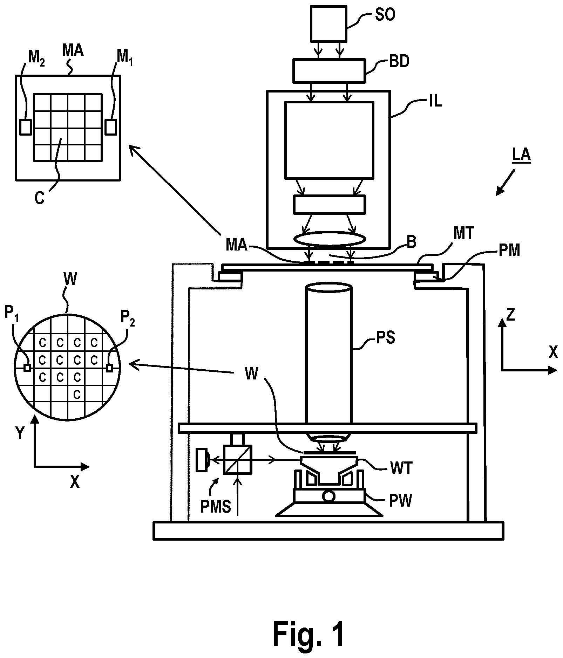

Figure 1 schematically depicts a lithographic apparatus LA. The lithographic apparatus LA includes an illumination system (also referred to as illuminator) IL configured to condition a radiation beam B (e.g., UV radiation, DUV radiation or EUV radiation), a mask support (e.g., a mask table) MT constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support MT, and is patterned by the pattern (design layout) present on patterning device MA. Having traversed the patterning device MA, the radiation beam B passes through the projection system PS, which focuses the beam onto a target portion C of the substrate W. With the aid of the second positioner PW and a position measurement system IF, the substrate support WT can be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks P1, P2. Although the substrate alignment marks P1, P2 as illustrated occupy dedicated target portions, they may be located in spaces between target portions. Substrate alignment marks P1, P2 are known as scribe-lane alignment marks when these are located between the target portions C.

To clarify the invention, a Cartesian coordinate system is used. The Cartesian coordinate system has three axes, i.e., an x-axis, a y-axis and a z-axis. Each of the three axes is orthogonal to the other two axes. A rotation around the x-axis is referred to as an Rx-rotation. A rotation around the y-axis is referred to as an Ry-rotation. A rotation around about the z-axis is referred to as an Rz-rotation. The x-axis and the y-axis define a horizontal plane, whereas the z-axis is in a vertical direction. The Cartesian coordinate system is not limiting the invention and is used for clarification only. Instead, another coordinate system, such as a cylindrical coordinate system, may be used to clarify the invention. The orientation of the Cartesian coordinate system may be different, for example, such that the z-axis has a component along the horizontal plane.

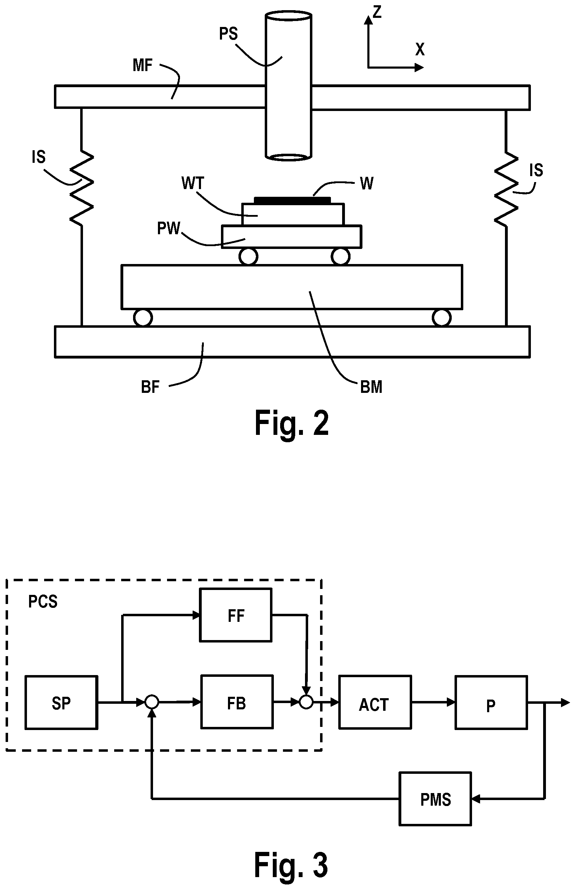

Figure 2 shows a more detailed view of a part of the lithographic apparatus LA of Figure 1. The lithographic apparatus LA may be provided with a base frame BF, a balance mass BM, a metrology frame MF and a vibration isolation system IS. The metrology frame MF supports the projection system PS. Additionally, the metrology frame MF may support a part of the position measurement system PMS. The metrology frame MF is supported by the base frame BF via the vibration isolation system IS. The vibration isolation system IS is arranged to prevent or reduce vibrations from propagating from the base frame BF to the metrology frame MF.

The second positioner PW is arranged to accelerate the substrate support WT by providing a driving force between the substrate support WT and the balance mass BM. The driving force accelerates the substrate support WT in a desired direction. Due to the conservation of momentum, the driving force is also applied to the balance mass BM with equal magnitude, but at a direction opposite to the desired direction. Typically, the mass of the balance mass BM is significantly larger than the masses of the moving part of the second positioner PW and the substrate support WT.

In an embodiment, the second positioner PW is supported by the balance mass BM. For example, wherein the second positioner PW comprises a planar motor to levitate the substrate support WT above the balance mass BM. In another embodiment, the second positioner PW is supported by the base frame BF. For example, wherein the second positioner PW comprises a linear motor and wherein the second positioner PW comprises a bearing, like a gas bearing, to levitate the substrate support WT above the base frame BF.

The position measurement system PMS may comprise any type of sensor that is suitable to determine a position of the substrate support WT. The position measurement system PMS may comprise any type of sensor that is suitable to determine a position of the mask support MT. The sensor may be an optical sensor such as an interferometer or an encoder. The position measurement system PMS may comprise a combined system of an interferometer and an encoder. The sensor may be another type of sensor, such as a magnetic sensor, a capacitive sensor or an inductive sensor. The position measurement system PMS may determine the position relative to a reference, for example the metrology frame MF or the projection system PS. The position measurement system PMS may determine the position of the substrate table WT and/or the mask support MT by measuring the position or by measuring a time derivative of the position, such as velocity or acceleration.

The position measurement system PMS may comprise an encoder system. An encoder system is known from for example, United States patent application US2007/0058173A1, filed on September 7, 2006, hereby incorporated by reference. The encoder system comprises an encoder head, a grating and an encoder sensor. The encoder system may receive a primary radiation beam and a secondary radiation beam. Both the primary radiation beam as well as the secondary radiation beam originate from the same radiation beam, i.e., the original radiation beam. At least one of the primary radiation beam and the secondary radiation beam is created by diffracting the original radiation beam with the grating. If both the primary radiation beam and the secondary radiation beam are created by diffracting the original radiation beam with the grating, the primary radiation beam needs to have a different diffraction order than the secondary radiation beam. Different diffraction orders are, for example, +1st order, -1st order, +2nd order and -2nd order. The encoder system optically combines the primary radiation beam and the secondary radiation beam into a combined radiation beam. An encoder sensor in the encoder head determines a phase or phase difference of the combined radiation beam. The encoder sensor generates a signal based on the phase or phase difference. The signal is representative of a position of the encoder head relative to the grating. One of the encoder head and the grating may be arranged on the substrate structure WT. The other of the encoder head and the grating may be arranged on the metrology frame MF or the base frame BF. For example, a plurality of encoder heads is arranged on the metrology frame MF, whereas a grating is arranged on a top surface of the substrate support WT. In another example, a grating is arranged on a bottom surface of the substrate support WT, and an encoder head is arranged below the substrate support WT.

The position measurement system PMS may comprise an interferometer system. An interferometer system is known from, for example, United States patent US6,020,964, filed on July 13, 1998, hereby incorporated by reference. The interferometer system may comprise a beam splitter, a mirror, a reference mirror and an interferometer sensor. A beam of radiation is split by the beam splitter into a reference beam and a measurement beam. The measurement beam propagates to the mirror and is reflected by the mirror back to the beam splitter. The reference beam propagates to the reference mirror and is reflected by the reference mirror back to the beam splitter. At the beam splitter, the measurement beam and the reference beam are combined into a combined radiation beam. The combined radiation beam is incident on the interferometer sensor. The interferometer sensor determines a phase or a frequency of the combined radiation beam. The interferometer sensor generates a signal based on the phase or the frequency. The signal is representative of a displacement of the mirror. In an embodiment, the mirror is connected to the substrate support WT. The reference mirror may be connected to the metrology frame MF. In an embodiment, the measurement beam and the reference beam are combined into a combined radiation beam by an additional optical component instead of the beam splitter.

The first positioner PM may comprise a long-stroke module and a short-stroke module. The short-stroke module is arranged to move the mask support MT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the first positioner PM is able to move the mask support MT relative to the projection system PS with a high accuracy over a large range of movement. Similarly, the second positioner PW may comprise a long-stroke module and a short-stroke module. The short-stroke module is arranged to move the substrate support WT relative to the long-stroke module with a high accuracy over a small range of movement. The long-stroke module is arranged to move the short-stroke module relative to the projection system PS with a relatively low accuracy over a large range of movement. With the combination of the long-stroke module and the short-stroke module, the second positioner PW is able to move the substrate support WT relative to the projection system PS with a high accuracy over a large range of movement.

The first positioner PM and the second positioner PW each are provided with an actuator to move respectively the mask support MT and the substrate support WT. The actuator may be a linear actuator to provide a driving force along a single axis, for example the y-axis. Multiple linear actuators may be applied to provide driving forces along multiple axis. The actuator may be a planar actuator to provide a driving force along multiple axis. For example, the planar actuator may be arranged to move the substrate support WT in 6 degrees of freedom. The actuator may be an electro-magnetic actuator comprising at least one coil and at least one magnet. The actuator is arranged to move the at least one coil relative to the at least one magnet by applying an electrical current to the at least one coil. The actuator may be a moving-magnet type actuator, which has the at least one magnet coupled to the substrate support WT respectively to the mask support MT. The actuator may be a moving-coil type actuator which has the at least one coil coupled to the substrate support WT respectively to the mask support MT. The actuator may be a voice-coil actuator, a reluctance actuator, a Lorentz-actuator or a piezo-actuator, or any other suitable actuator.

The lithographic apparatus LA comprises a position control system PCS as schematically depicted in Figure 3. The position control system PCS comprises a setpoint generator SP, a feedforward controller FF and a feedback controller FB. The position control system PCS provides a drive signal to the actuator ACT. The actuator ACT may be the actuator of the first positioner PM or the second positioner PW. The actuator ACT drives the plant P, which may comprise the substrate support WT or the mask support MT. An output of the plant P is a position quantity such as position or velocity or acceleration. The position quantity is measured with the position measurement system PMS. The position measurement system PMS generates a signal, which is a position signal representative of the position quantity of the plant P. The setpoint generator SP generates a signal, which is a reference signal representative of a desired position quantity of the plant P. For example, the reference signal represents a desired trajectory of the substrate support WT. A difference between the reference signal and the position signal forms an input for the feedback controller FB. Based on the input, the feedback controller FB provides at least part of the drive signal for the actuator ACT. The reference signal may form an input for the feedforward controller FF. Based on the input, the feedforward controller FF provides at least part of the drive signal for the actuator ACT. The feedforward FF may make use of information about dynamical characteristics of the plant P, such as mass, stiffness, resonance modes and eigenfrequencies.

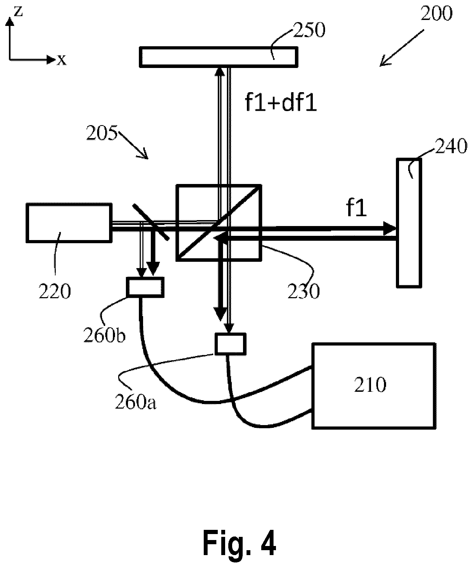

Figure 4 depicts an interferometer system 200, as an example of an incremental position measurement system according to an embodiment of the invention. The interferometer system 200 comprises an interferometer 205, as an incremental measurement device, and a processing system 210. The interferometer 205 comprises a laser source 220, a beamsplitter 230, a movable object 240, a reference 250 and detector units 260a, 260b. The interferometer 205 is a heterodyne interferometer. The laser source 220 is a heterodyne laser source and provides a radiation beam that has two combined wavelengths. One of the wavelengths has a frequency f1. The other wavelength has a frequency of f1+df1. Part of the radiation beam is directed to detector unit 260b. A remaining part of the radiation beam is directed to a beamsplitter 230. The radiation beam is split by the beamsplitter 230. A first part of the radiation beam propagates to the movable object 240 and is reflected back to the beamsplitter 230. A second part of the radiation beam propagates to the reference 250 and is reflected back to the beam splitter 230. The radiation beam is further propagated to the detector unit 260a. The radiation beam incident on the detector unit 260a represents a position of the movable object 240. The detector unit 260a is a measurement detector that is arranged to provide a measurement signal to the processing system 210. The detector unit 260b is a reference detector that is arranged to provide a reference signal to the processing system 210. A movement of the movable object 240 causes a change in frequency in the radiation beam incident on detector unit 260a. The processing system 210 is arranged to derive a position of the movable object 240 based on the change of the frequency in the radiation beam incident on detector unit 260a.

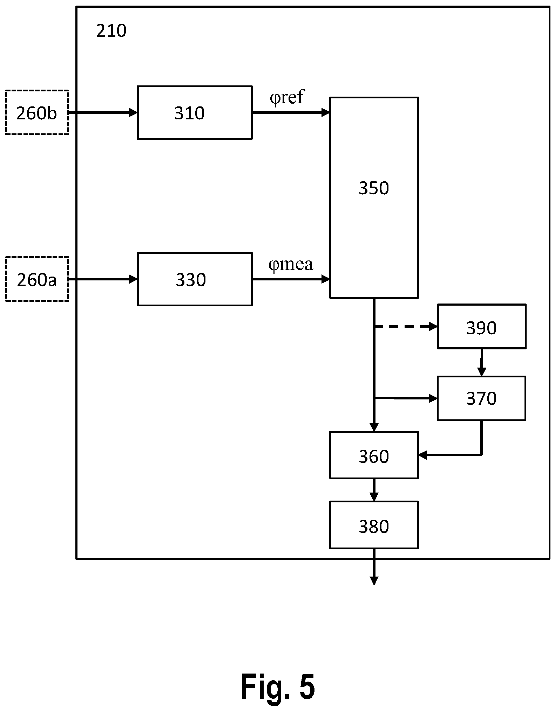

Figure 5 provides a schematic view of the processing system 210. The processing system 210 comprises an input to receive the measurement signal and the reference signal from detector units 260a and 260b, respectively. The measurement signal is representative for a position of the movable object. This position may be a relative and/or an absolute position.

The processing system 210 comprises a phase calculator 310 to calculate a reference phase φref of the reference signal. The reference signal may be a sine-shaped signal. The phase calculator 310 may determine the phase or a change in phase of the sine-shape over time.

In an embodiment, the interferometer system 200 does not have detector unit 260b. Instead, the processing system 210 may use the control signal of an AOM (Acoustic Optical Modulator) that generates the radiation beam to determine the reference phase. Alternatively, another control signal for controlling the laser source 220 is used to determine the reference phase. The detector unit 260b may be used to detect changes in the frequency of the radiation beam caused by an optical fiber propagating the radiation beam from the laser source 220 to the interferometer 205.

The processing system 210 comprises a phase calculator 330 arranged to calculate a measurement phase φmea of the measurement signal. The measurement signal may be substantially sine-shaped. The phase calculator 330 may determine the phase or a change in phase of the sine-shape over time. The phase difference between the measurement phase φmea and the reference phase φref in radians divided by 2pi may be referred to as an interferometer count.

The phase calculators 310 and 330 may be part of a so-called "phase measurement board" or "phase lock-in amplifier" capable of detecting the phase and the phase difference between the signals received by the detector units 260a and 260b.

The processing system 210 may comprise a frequency generator arranged to determine a measurement frequency of the measurement signal. The measurement frequency may be dependent on the frequency of the radiation beam as provided by the laser source 220. When the movable object 240 is stationary, the measurement frequency is typically equal to the split frequency determined by frequencies f1 and df1. The split frequency may be several MHz, for example between 1-20 MHz, for example 10, 12 or 15 MHz. In addition, when the movable object 240 moves, the Doppler effect causes the measurement frequency to change with a so-called Doppler shift.

The measurement frequency may be generated by the frequency generator. The frequency generator may use the measurement signal from the detector unit 260a as an input. Alternatively or in addition, speed information about the movable object 240 may be used to determine the measurement frequency. In an embodiment, the frequency generator does not use the measurement signal as an input, but uses other information as an input, for example speed information of the movable object 240, or for example, by using information about the Doppler shift.

In the processing system 210, a count determination unit 350 is provided. The count determination unit 350 is arranged to determine a number of counts, e.g. a change in counts, on the basis of the measurement phase φmea and the reference phase φref. This number of counts or change in counts is representative for a position or a change in position of the movable object 240. The counts may be a combination of an integer number of full counts and a partial count, e.g. between 0 and 1, wherein one count is representative for an interferometer period. The measurement value comprising the determined number of counts is guided to a cyclic error correction unit 360.

In the cyclic error correction unit 360, a correction of a cyclic error value may be applied to the counts on the basis of a cyclic error correction value obtained from a lookup table 370 in order to compensate the error caused by a cyclic error in the measurement value. After correction for the cyclic error, the corrected measurement value is fed into a position determination unit 370.

In the position determining unit 380, the position of the movable object 204 may be determined on the basis of the corrected counts, i.e. the counts that were corrected on the basis of the cyclic correction value and the measurement value. In some applications, the counts may be used as position signal. In such application, the position determining unit 380 may not be needed.

In the count determination unit 350, the interferometer count of a heterodyne interferometer may be obtained by fitting the measurement phase φmea over a predefined time interval. In such interferometer system 200, cyclic error values will have a dependency that is related to the sampling window over which a count value is determined. As a result, the cyclic error values are averaged out if the cyclic error frequency coincides with an integer multiple of the position sampling frequency. This means that the cyclic error value determined by the interferometer system 200, in particular the processing system 210, is suppressed by averaging when moving at a velocity of integer multiples of the position sampling frequency multiplied by the interferometer period. In other words, the cyclic error value, as determined by the interferometer system 200, or more generally the incremental position measurement system, may also depend on the velocity of the movable object 240. This velocity dependency is for example, as explained above, induced by the sampling rate of the processing system 210.

In this application, the cyclic error value, as determined by the interferometer system 200, or more generally the incremental position measurement system, is referred to as velocity dependent cyclic error value, since this cyclic error value may be dependent on the velocity of the movable object 240 due to velocity dependent suppression of the cyclic error value in the processing system 210. The cyclic error itself, i.e. the (optical) cause of the cyclic error in the interferometer 205, does not have to be dependent on the velocity of the movable object 240.

In known prior art interferometer systems, such as disclosed in US 2019/265019, the contents of which are incorporated herein its entirety, the velocity dependency of the cyclic error value is not taken into account as the cyclic error correction is only determined and applied for a small range of velocities of the movable object 240.

However, when it is desired to provide a cyclic error lookup table 370 that can be effectively used at both lower and higher velocities of the movable object 240, the velocity dependency of the cyclic error value cannot be ignored.

To allow cyclic error correction at low and high velocities of the movable object 240, the lookup table 370 of the processing system 210 shown in Figure 5 is arranged to take into account the velocity dependency of the cyclic error value. The lookup table 370 may for example be configured as a two-dimensional matrix defining a relationship between a velocity dependent cyclic error value or a velocity dependent correction value and the measurement value, in particular the partial count of the counts, and the velocity of the movable object. Thus, the lookup table 370 of the processing system 210 can provide a velocity dependent cyclic error value or a velocity dependent correction value in dependence of both the measurement value and the velocity of the movable object 240.

In order to use the lookup table 370, the velocity of the movable object 240 has to be known. In an embodiment, the velocity of the movable object 240 may be determined on the basis of a position change in successive measured positions of the movable object divided by time between measurements of the successive measured positions, e.g. a number of counts as determined by the count determination unit 350 divided by the time between the measurements of these counts. Any other method to provide the velocity of the movable object 240 may also be used.

To determine the velocity dependent cyclic error values or velocity dependent correction values of the lookup table 370, a velocity dependent cyclic error value model and/or a velocity dependent correction value model may be used. Such velocity dependent cyclic error value model and/or velocity dependent correction value model defines a relationship between a cyclic error value and the measurement value, e.g. the partial count of the interferometer signal, and the velocity of the movable object.

In an embodiment, a sine and/or cosine function or a spline function can be used to define a relationship between a cyclic error value and a partial count of the interferometer signal. Further, it has been found that a sinc-function can be used to define the relationship between a cyclic error value and the velocity of the movable object 240, in particular when a so-called flat window algorithm to determine the counts of the interferometer is used.

The relationship between the cyclic error value and the partial count of the interferometer signal may comprise multiple harmonics, for example multiple harmonics of the sine and/or cosine function or the spline function. Correspondingly, the relationship between the cyclic error value and the velocity of the movable object 240, may comprise multiple harmonics, for example multiple harmonics of the sinc-function.

In an embodiment, the cyclic error value model or cyclic error correction value model may comprise multitude of cosine and sine functions having different frequencies, since cyclic errors can for example have a repeating pattern that repeats every 2 counts (1/2 harmonic cyclic error ), every count (1^{st} harmonic cyclic error), every 0.5 counts (2^{nd} harmonic cyclic error). Thus, the different harmonics can be used to model the different repeating patterns of the cyclic errors.

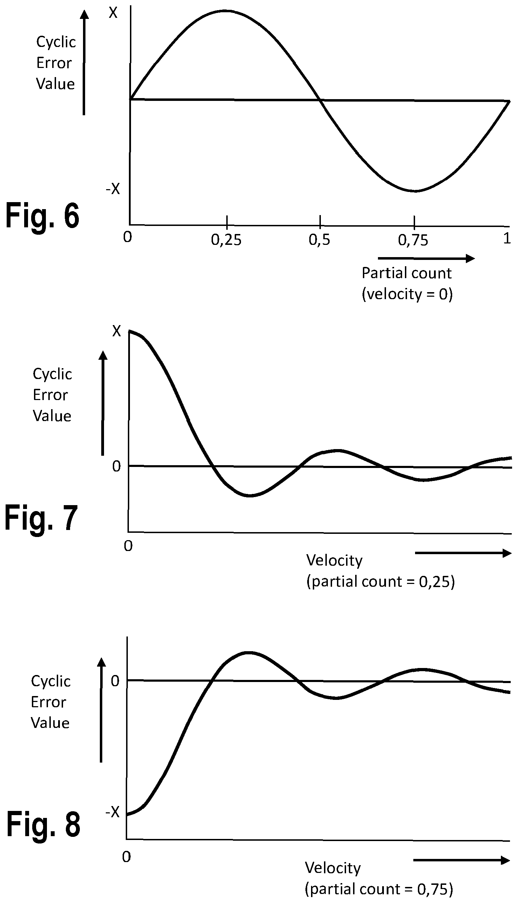

Figure 6 shows schematically a relationship between the cyclic error value and a measurement value, when the velocity of the movable object 240 is zero. In this example the cyclic error value is defined by a sine function. In practice, this relationship between cyclic error value and measurement value, e.g. partial count, can often be described as a combination of a sine function and a cosine function.

Figure 7 shows schematically a relationship between the cyclic error value and the velocity of the movable object 240, when the partial count is 0,25. This function shows that the cyclic error will have different values related to different velocities of the movable object 240. In particular, at zero velocity the cyclic error will have a maximum value of X. In dependence of the velocity of the movable object 240, the cyclic error value will be different following a sinc function as shown in Figure 7.

Figure 8 shows another relationship between the cyclic error value and the velocity of the movable object 240, wherein the partial count is 0,75. At zero velocity the cyclic error will have a maximum negative value of -X and with increasing velocities of the movable object 240, the cyclic error value will have other values following the sinc function shown in Figure 8.

The cyclic error values as shown in Figures 7 and 8 may also be determined for other partial counts to create a two-dimension matrix having cyclic error values in dependence of the measurement value, in particular partial count, as determined in the processing system 210 and the velocity of the movable object 240.

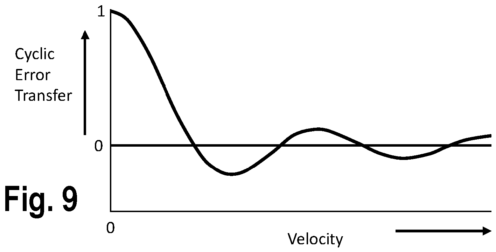

Figure 9 shows a sinc function describing the relationship between a velocity dependent transfer value of the cyclic error value and the velocity of the movable object 240. At zero velocity of the movable object 240, the velocity dependent transfer value is one.

In an embodiment, the combination of the relationship between the cyclic error value and the measurement value shown in Figure 6 and the velocity dependent transfer value shown in Figure 9 can be used to determine the velocity dependent cyclic error value. This combination defines a velocity dependent cyclic error value model and/or a velocity dependent correction value model that can be applied as followed. On the basis of the relationship between the cyclic error value and the measurement value at zero velocity shown in Figure 6, the cyclic error value at the zero velocity can be determined. On the basis of the velocity of the movable object 240, the velocity dependent transfer value associated with the velocity of the movable object 240 can be determined. By multiplying the cyclic error value at zero velocity with the velocity dependent transfer value associated with the velocity of the movable object 240, the velocity dependent cyclic error value can be determined.

Thus, the combination of sine/cosine functions to describe the relationship between cyclic error and measurement value and a sinc function to describe the relationship between cyclic error and the velocity of the movable object 240, can be used to define a velocity dependent cyclic error value model and/or a velocity dependent correction value model.

By fitting, in a cyclic error calibration unit 390, these functions on measurement values and associated cyclic errors of the interferometer signal, the velocity dependent cyclic error values and/or velocity dependent correction values can be determined and stored in the lookup table 370 and/or in one or more correction functions.

Optionally, the cyclic error fitting may be conducted in an iterative manner to improve the fitting result, for example when the cyclic errors are relatively large or if the measurement noise is relatively high. An iterative fitting approach to improve the accuracy of the cyclic error correction may also be applied in case the measurement system has a control system with a control bandwidth, in which at certain velocities the cyclic error may (partially) fall within the control bandwidth.

The calibration method to fit the velocity dependent cyclic error values may be an inline calibration method and/or an offline calibration method. Not all fitting parameters need to be calibrated at once. For instance, if there is a reason to assume that the cyclic error lookup table has shifted over time, only the measurement value, e.g. measurement phase/partial count, dependency of the cyclic error value may be calibrated, and the velocity dependent transfer value may remain unchanged.

By extending the fitting of the cyclic errors with a velocity dependent correction factor, as proposed herein, cyclic errors are fitted more accurately, independent on the velocity trajectory during the measurements of multiple positions of the movable object 240 for fitting data. As a result, it is no longer required to have strict velocity requirements when fitting and correcting the cyclic errors. Cyclic errors can be fitted to measurements conducted at a varying velocity of the movable object 240 and still be applied correctly for a near static velocity of the movable object 240, since the velocity of the movable object 240 will be taken into account when fitting the cyclic errors.

Hereinabove, a processing system 210 is described in which a velocity dependent cyclic error value is corrected using a lookup table 370. In other embodiments, the fitted cyclic error correction parameters may be describe in a correction function or in a combination of a lookup table and a correction function. Any other suitable way of storing the correction values for the cyclic errors may also be applied.

Instead of an interferometer, the incremental position measurement system may comprise an encoder, for example a heterodyne encoder or a homodyne encoder. The incremental position measurement system may be an optical incremental system, or may alternatively be any other kind of incremental measurement system, for example a magnetic encoder. The methods described herein may be applied in a homodyne interferometer system, a heterodyne interferometer system, a heterodyne encoder system and a homodyne encoder system. For some of these systems, the velocity dependency of the cyclic error value or cyclic error correction value may be different and other functions than a sinc function may be desired to describe this velocity dependency.

US 2019/265019, the contents of which are incorporated herein its entirety, discloses a method for calibration of an incremental position measurement system to take position dependent cyclic errors into account. This position dependent cyclic error correction may be combined with the velocity dependent cyclic error value correction described in this application in order to provide both position dependent and velocity dependent cyclic error value correction in a single incremental position measurement system.

In an embodiment, the movable object 240 is the substrate table WT or the support structure MT, in particular a target, such as a reflective surface mounted on the substrate table WT or the support structure MT. The movable object 240 may also be an optical component of the projection system PS. The optical component may comprise a mirror or a lens. The optical component may be arranged to follow a desired trajectory while a target portion C is being exposed.

The processing system 210 may be implemented differently than described. For example, parts of processing system 210 may be implemented as a single unit or may be split over several units. The processing system 210 may be a completely digital processing system 210 or may be a combination of a digital and analogue processing system 210. Detector units 260a, 260b may be part of the processing system 210.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below. Other aspects of the invention are set out as in the following numbered clauses:
1. A processing system for an incremental position measurement system arranged to determine a position of a movable object,
   wherein the processing system comprises an input to receive, from an incremental measurement device of the incremental position measurement system, a signal representative for a position of the movable object,
   wherein the processing system is arranged to determine a velocity dependent cyclic error value and/or a velocity dependent correction value of the incremental position measurement system based on the signal and a velocity of the movable object.
2. The processing system of clause 1, wherein the processing system is configured to:
   measure multiple positions of the movable object;
   determine, for each of the multiple positions, a cyclic error value of the incremental position measurement system; and
   determine the velocity dependent cyclic error value and/or the velocity dependent correction value of the incremental position measurement system based on the determined cyclic error values and the velocity of the movable object associated with the determined cyclic error values.
3. The processing system of clause 2, wherein the processing system is arranged to:
   provide a velocity dependent cyclic error value model and/or a velocity dependent correction value model,
   fit the determined cyclic errors on the velocity dependent cyclic error value model and/or the velocity dependent correction value model, and
   store the fitted velocity dependent cyclic error model value and/or the fitted velocity dependent correction value model in a correction function and/or a lookup table.
4. The processing system of clause 3, wherein the velocity dependent cyclic error value model and/or the velocity dependent correction value model comprises a sinc-function to define a relationship between a cyclic error and the velocity of the movable object.
5. The processing system of clause 3 or 4, wherein the velocity dependent cyclic error value model and/or the velocity dependent correction value model comprises a sine and/or cosine function or a spline function to define a relationship between a cyclic error and the measurement signal.
6. The processing system of any of the clauses 3-5, wherein the lookup table is a two-dimensional matrix defining a relationship between the velocity dependent cyclic error value or the velocity dependent correction value and a measurement value and the velocity of the movable object.
7. The processing system of any of the clauses 1-6, wherein the processing system is arranged to correct a measurement signal of the incremental position measurement system using the velocity dependent cyclic error value and/or the velocity dependent correction value in dependence of the velocity of the movable object during measurement of the measurement signal.
8. The processing system of any of the clauses 1-7, wherein the velocity of the movable object is determined on the basis of a position change in successive measured positions of the movable object divided by time between measurements of the successive measured positions.
9. An incremental position measurement system comprising:
   an incremental measurement device, and
   the processing system of any of the clauses 1-8.
10. The incremental position measurement system of clause 9, wherein the incremental measurement device is an encoder or an interferometer.
11. A positioning system to position a movable object, the positioning system comprising the incremental position measurement system of clause 9 or 10.
12. An exposure apparatus comprising the positioning system of clause 11.
13. A projection system for an optical lithography system, comprising the positioning system of clause 11.
14. A method to determine a position of a movable object using an incremental position measurement system comprising an incremental measurement device and a processing system, comprising the steps of:
   measuring, using the incremental measurement device, a signal representative for a position of the movable object, and
   determining, using the processing system, a cyclic error value and/or a cyclic error correction value of the incremental position measurement system based on the signal and a velocity of the movable object.
15. The method of clause 14, comprising correcting a measurement value of the incremental position measurement system based on the velocity dependent cyclic error value and/or the velocity dependent correction value in dependence of the velocity of the movable object during measurement of the measurement value.
16. The method of clause 15, wherein correcting the measurement value comprises using a correction function and/or a lookup table based on a velocity dependent cyclic error value model and/or a velocity dependent correction value model.
17. A method for calibration of an incremental position measurement system arranged to determine a position of a movable object, comprising the steps of:
   measuring multiple positions of the movable object;
   determining, for each of the multiple positions, a cyclic error of the incremental position measurement system; and
   determining a velocity dependent cyclic error value and/or a velocity dependent correction value of the incremental position measurement system based on the determined cyclic errors and the velocity of the movable object associated with the determined cyclic errors.
18. The method of clause 17, comprising the steps of:
   providing a velocity dependent cyclic error value model and/or a velocity dependent correction value model,
   fitting the determined cyclic errors on the velocity dependent cyclic error value model and/or the velocity dependent correction value model, and
   storing the fitted velocity dependent cyclic error value model and/or the fitted velocity dependent correction value model in a correction function and/or a lookup table.
19. The method of clause 18, wherein the velocity dependent cyclic error value model and/or the velocity dependent correction value model comprises a sinc-function to define a relationship between a cyclic error and the velocity of the movable object.
20. The method of clause 18 or 19, wherein the velocity dependent cyclic error value model and/or the velocity dependent correction value model comprises a sine and/or cosine function or a spline function to define a relationship between a cyclic error and a measurement value of the measurement signal.
21. The method of any of the clauses 17-20, wherein the lookup table is a two-dimensional matrix defining a relationship between the velocity dependent cyclic error value or the velocity dependent correction value and a measurement value and the velocity of the movable object.
22. The method of any of the clauses 17-21, wherein the method is an inline calibration method and/or an offline calibration method.

## Claims

1. A processing system for an incremental position measurement system arranged to determine a position of a movable object,
wherein the processing system comprises an input to receive, from an incremental measurement device of the incremental position measurement system, a signal representative for a position of the movable object,
wherein the processing system is arranged to determine a velocity dependent cyclic error value and/or a velocity dependent correction value of the incremental position measurement system based on the signal and a velocity of the movable object.

2. The processing system of claim 1, wherein the processing system is configured to:
measure multiple positions of the movable object;
determine, for each of the multiple positions, a cyclic error value of the incremental position measurement system; and
determine the velocity dependent cyclic error value and/or the velocity dependent correction value of the incremental position measurement system based on the determined cyclic error values and the velocity of the movable object associated with the determined cyclic error values.

3. The processing system of claim 2, wherein the processing system is arranged to:
provide a velocity dependent cyclic error value model and/or a velocity dependent correction value model,
fit the determined cyclic errors on the velocity dependent cyclic error value model and/or the velocity dependent correction value model, and
store the fitted velocity dependent cyclic error model value and/or the fitted velocity dependent correction value model in a correction function and/or a lookup table.

4. The processing system of any of the claims 1-3, wherein the processing system is arranged to correct a measurement signal of the incremental position measurement system using the velocity dependent cyclic error value and/or the velocity dependent correction value in dependence of the velocity of the movable object during measurement of the measurement signal.

5. The processing system of any of the claims 1-4, wherein the velocity of the movable object is determined on the basis of a position change in successive measured positions of the movable object divided by time between measurements of the successive measured positions.

6. An incremental position measurement system comprising:
an incremental measurement device, and
the processing system of any of the claims 1-5.

7. A positioning system to position a movable object, the positioning system comprising the incremental position measurement system of claim 6.

8. An exposure apparatus comprising the positioning system of claim 7.

9. A projection system for an optical lithography system, comprising the positioning system of claim 7.

10. A method to determine a position of a movable object using an incremental position measurement system comprising an incremental measurement device and a processing system, comprising the steps of:
measuring, using the incremental measurement device, a signal representative for a position of the movable object, and
determining, using the processing system, a cyclic error value and/or a cyclic error correction value of the incremental position measurement system based on the signal and a velocity of the movable object.

11. The method of claim 10, comprising correcting a measurement value of the incremental position measurement system based on the velocity dependent cyclic error value and/or the velocity dependent correction value in dependence of the velocity of the movable object during measurement of the measurement value.

12. The method of claim 11, wherein correcting the measurement value comprises using a correction function and/or a lookup table based on a velocity dependent cyclic error value model and/or a velocity dependent correction value model.

13. A method for calibration of an incremental position measurement system arranged to determine a position of a movable object, comprising the steps of:
measuring multiple positions of the movable object;
determining, for each of the multiple positions, a cyclic error of the incremental position measurement system; and
determining a velocity dependent cyclic error value and/or a velocity dependent correction value of the incremental position measurement system based on the determined cyclic errors and the velocity of the movable object associated with the determined cyclic errors.

14. The method of claim 13, comprising the steps of:
providing a velocity dependent cyclic error value model and/or a velocity dependent correction value model,
fitting the determined cyclic errors on the velocity dependent cyclic error value model and/or the velocity dependent correction value model, and
storing the fitted velocity dependent cyclic error value model and/or the fitted velocity dependent correction value model in a correction function and/or a lookup table.

15. The method of claim 13 or 14, wherein the method is an inline calibration method and/or an offline calibration method.
